# EUROPEAN PATENT APPLICATION

(11) **EP 3 290 147 A1**
(43) Date of publication of application: **07.03.2018**
(21) Application number: 17150213.1
(22) Date of filing: 04.01.2017
(51) Int. Cl.: B23K 35/26, C25D 3/60, C22C 13/00, B23K 101/36

(54) **TIN-BISMUTH-LEAD TERNARY ALLOY SOLDER COMPOSITION USING ELECTROPLATING**

(30) Priority: 31.08.2016 KR 20160111587
(71) Applicant: Hojin Platech Co. Ltd., Gyeonggi-do 425-100 (KR)
(72) Inventor: Kim, Pan Soo, 16851 Yongin-si, Gyeonggi-do (KR); Lee, Duk Haeng, Bucheon-si, Kyunggi-do 14700 (KR); Jung, Woon Suk, 15454 Ansan-si, Gyeonggi-do (KR); Jeong, Kyung-Taek, 34809 Daejeon-si (KR); Kim, Joo-Young, 07438 Seoul (KR); Kim, Jong-Uk, 16396 Suwon-si (KR)
(74) Representative: Gulde & Partner

(57) **Abstract**

The present invention relates to a Sn-Pb-Bi ternary alloy solder composition. In the present invention, since an amount of Bi is 5 wt% or less, and a melting point of the composition is determined in 146-225°C, soldering at a lower heating temperature than a common temperature is possible. Breaking phenomenon due to the inclusion of bismuth is not found.

## Description

### BACKGROUND OF THE INVENTION

### Field of the Invention

The present invention relates to a solder composition, and more particularly, to a lead solder.

### Description of the Related Art

Soldering is an interconnection technique by dissolving and putting a solder between a base material and a base material, and then heating. Soldering is applied in various methods in various fields. In a solar cell field, a soldering technique is used in a work for forming an electrode and in a work for manufacturing a solar cell module by arranging and connecting substrates on which an electrode is formed. Even though various technical limitations come up for the commercialization of a solar cell, efforts to secure economic feasibility are important in addition to the overcome of the technical limitations. Cost rationality is the factor of efficiency in the end and is the companion of technique. Industrial entities in this field face the challenge of realizing better technology and greater economics at the same time.

In manufacturing solar cell modules used for photovoltaic power generation, as mentioned above, each solar cell substrate is connected in series by using tabbing ribbons to produce a high output solar cell module. In this process, one electrode and the other electrode of the solar cell are subjected to soldering at a high temperature of about 250°C using a taping ribbon, a multi-wire, or a smart wire. However, there is some difficulty to solve in these technologies. There arises a problem of a peel-off phenomenon between a silicon wafer and a plating electrode due to a large difference in thermal expansion coefficient between the silicon and the plating electrode. Particularly, this phenomenon is a factor of decreasing the efficiency of a solar cell in a Hetero Junction Solar Cell (HJC), and becomes large disturbing factors in the industrialization of a plated electrode in a solar cell industry.

Conventional tabbing ribbons were manufactured by hot dip coating of a solder mainly 63% tin and 37% lead of low melting point on copper or aluminum with a width of about 1.5-2 mm. When a lead-free solder is used, the melting point is relatively high and expensive, so it is not widely used. On the other hand, a technology using a low melting point solder using a Sn-In alloy or a Sn-Bi-Ag alloy has been known in the technologies such as Multi Wire and Smart Wire. However, serious limitations such as the braking of a solder due to physical impact occur, as well as a high cost problem.

The alloy of 63% tin and 37% lead has a eutectic point of about 183°C, but is required to be heated to 240-250°C for smooth soldering. As a way to overcome these problems, there is a method of lowering the eutectic point to 139 °C by using tin and bismuth alloy on copper metal. This process alloy has a high strength in the metal characteristics after solidification, but is very weak in physical impact and has a defect that is well fragile as described above.

Meanwhile, Korean Patent No. 690245 suggests tin/lead (Sn/Pb), tin/silver/copper (Sn/Ag/Cu), tin/silver (Sn/Ag), tin/copper (Sn/Cu), tin/bismuth (Sn/Bi), tin/zinc/bismuth (Sn/Zn/Bi), tin/silver/bismuth (Sn/Ag/Bi), tin/silver/zinc (Sn/Ag/Zn), indium/tin (In/Sn), indium/silver (In/Ag), tin/lead/silver (Sn/Pb/Ag), indium/lead (In/Pb), tin (Sn), tin/lead/bismuth (Sn/Pb/Bi), and tin/lead/bismuth/silver (Sn/Pb/Bi/Ag) as soldering materials having a low melting point. However, the solder alloy of the patent document is merely a theoretical composition using a physical property that the melting point of indium, bismuth, lead, tin, and silver is low. If the specific composition ratio is not specified, it is not melted. The patent document suggests a component ratio of 43/57 for a Sn-Bi alloy, and a component ratio of 89/3/8 for a Sn/Zn/Bi alloy. However, since the amount of a bismuth component is too large, it is easy to be fragile and cracks occur. In addition, bismuth is relatively expensive.

Accordingly, the present invention has been completed through researches and trial and error for a long time in order to solve such limitations.

### SUMMARY OF THE INVENTION

Accordingly, an object of the present invention is to secure a technology capable of low-cost and low-melting-point soldering. To this end, the present invention provides a composition using a tin/lead/bismuth alloy as a solder material, which can reduce the content of bismuth and can be soldered at a low melting point at the same time.

On the other hand, other unspecified objects of the present invention will be further considered within the scope of the following detailed description and easily deduced from the effects thereof.

To achieve these objects and other advantages, there is provided in an aspect of the present invention, a Sn-Pb-Bi ternary alloy solder composition including 5 wt% or less of Bi, wherein a melting point of the Sn-Pb-Bi ternary alloy solder is determined in 146-225°C range.

In a preferred embodiment of the present invention, an amount of Pb may be 1-36 wt%. In addition, an amount of Bi is maintained in the 4wt% range.

In another preferred embodiment, the Sn-Pb-Bi ternary alloy solder composition includes 2.5-5 wt% of Bi, 1-36 wt% of Pb, and a remaining amount of Sn.

In a preferred embodiment of the present invention, there is provided a method of electroplating for obtaining a Sn-Pb-Bi ternary alloy solder composition, wherein a Sn-Pb alloy is used as a positive electrode, and metal ions in a plating bath include stannous methanesulfonic acid, lead methanesulfonic acid, and bismuth methanesulfonic acid.

In addition, there is provided in a second aspect of the present invention, a solar cell module manufactured by connecting an electrode and another electrode of a substrate by an interconnect medium using the Sn-Pb-Bi ternary alloy solder composition.

In a preferred embodiment, the interconnect medium may be used for one of a tabbing ribbon, a multi bus bar wire, and a smart wire.

### EFFECTS OF THE INVENTION

According to the present invention, a solder composition capable of soldering at a low melting point can be obtained by using a tin/lead/bismuth alloy as a soldering material, wherein the breaking phenomenon of a solder may be prevented by lowering the bismuth content to 5 wt% or less.

On the other hand, even if the effects are not explicitly mentioned here, the effects described in the following specification, which are expected by the technical features of the present invention, and the provisional effects thereof are treated as described in the specification of the present invention.

### BRIEF DESCRIPTION OF THE DRAWINGS

FIG. 1 is a graph showing the measured result of a melting point by DSC with respect to a ternary alloy plated composition according to Example 5.
FIG. 2 is a graph showing the measured result of a melting point by DSC with respect to a ternary alloy plated composition according to Example 6.
FIG. 3 is a graph showing the measured result of a melting point by DSC with respect to a ternary alloy plated composition according to Example 7.
FIG. 4 is a graph showing the measured result of a melting point by DSC with respect to a ternary alloy plated composition according to Example 8.
FIG. 5 is a graph showing the measured result of a melting point by DSC with respect to a ternary alloy plated composition according to Example 9.
FIG. 6 is a graph showing the measured result of a melting point by DSC with respect to a ternary alloy plated composition according to Example 10.
FIG. 7 is a graph showing the measured result of a melting point by DSC with respect to a ternary alloy plated composition according to Example 11.
FIG. 8 is a graph showing the measured result of a melting point by DSC with respect to a ternary alloy plated composition according to Example 12.
FIG. 9 is a graph showing the measured result of a melting point by DSC with respect to a ternary alloy plated composition according to Example 13.
FIG. 10 is a graph showing the measured result of a melting point by DSC with respect to a ternary alloy plated composition according to Example 14.
FIG. 11 is a graph showing the measured result of a melting point by DSC with respect to a ternary alloy plated composition according to Example 15.
FIG. 12 is a graph showing the measured result of a melting point by DSC with respect to a ternary alloy plated composition according to Example 16.
FIG. 13 is a graph showing the measured result of a melting point by DSC with respect to a ternary alloy plated composition according to Example 17.
FIG. 14 is a graph showing the measured result of a melting point by DSC with respect to a ternary alloy plated composition according to Example 18.
FIG. 15 is a graph showing the measured result of a melting point by DSC with respect to a ternary alloy plated composition according to Example 19.
FIG. 16 is a graph showing the measured result of a melting point by DSC with respect to a ternary alloy plated composition according to Example 20.
FIG. 17 is a graph showing the measured result of a melting point by DSC with respect to a ternary alloy plated composition according to Example 21.

### DETAILED DESCRIPTION OF THE INVENTION

In the following description of the present invention, a detailed description of relevant known functions and configurations incorporated herein will be omitted when it may obscure the gist of the present invention.

The inventors of the present invention have studied the properties of metals capable of low cost and low melting point soldering, and in particular studied the eutectic point of tin/bismuth/lead ternary alloys. When the total amount of bismuth is high, there is a problem of brittleness due to physical impact. Bismuth is also relatively expensive. In order to solve the problems of high cost and brittleness at the same time, studying the eutectic point and phase equilibrium coefficient of tin/bismuth/lead, it is possible to obtain a low melting point solder by adding a certain amount of lead to the tin/bismuth alloy. And it was confirmed through experiments.

Theoretical calculations of the phase equilibrium of tin/lead/bismuth ternary alloys have shown that low melting point alloys of 140-150°C are possible, but the low melting point properties of the ternary alloy compositions have to be found as experimental data. These studies and experiments took many years or more. In order to confirm the practical melting point, the following two methods were used to conduct the experiment.

On the other hand, in the tin/lead/bismuth ternary alloy composition, as the content of bismuth increased, it was found that the alloy was weaker due to physical impact after solidification, and the content of bismuth was expected to be 5 wt% or less.

First, solders having the component ratios of ternary alloy compositions were prepared using each metal powder according to the following examples, and melting points thereof were measured using Differential Scanning Calorimeter (DSC).

### Example 1

A ternary alloy composition of 91.9% by weight of tin, 5% by weight of lead, and 3.1% by weight of bismuth. As a result of the DSC measurement, the melting point range was 166.8 to 220.6°C.

### Example 2

A ternary alloy composition of 93.1% by weight of tin, 4.0% by weight of lead, and 2.9% by weight of bismuth. As a result of the DSC measurement, the melting point range was 167.6 to 221.8°C.

### Example 3

A ternary alloy composition of 94.3% by weight of tin, 3.0% by weight of lead, and 2.7% by weight of bismuth. As a result of the DSC measurement, the melting point range was 166.4 to 226.3°C.

### Example 4

A ternary alloy composition of 95.5% by weight of tin, 2.0% by weight of lead, and 2.5% by weight of bismuth. As a result of the DSC measurement, the melting point range was 166.4 to 226.3°C.

The resulting values of the melting points for Examples 1 to 4 are lower than 240 to 250°C which is a heating temperature of a solder of tin 63% and lead 37%, used during plating the tabbing ribbon of a solar cell.

Second, an alloy ratio were realized by electroplating. A plating bath for using thereof for plating was prepared. As the electrolyte, an alkanesulfonic acid-based electrolyte may be used. Particularly, methanesulfonic acid, 1-propanesulfonic acid, 2-propanesulfonic acid, 1-butanesulfonic acid, pentanesulfonic acid, etc. may be used. One of the alkanesulfonic acids may be used alone or two or more thereof may be used in combination, and methanesulfonic acid is preferable. The metal ion preferably include stannous methanesulfonic acid, lead methanesulfonic acid, and bismuth methanesulfonic acid.

Meanwhile, as additives, a surfactant, a particle control agent, a complexing agent, a tin antioxidant, etc. may be used. Preferably, additives such as octyl phenol ethoxylate as a surfactant and an additive for obtaining a uniform alloy composition, Tamol NN8906, phenyl urea as a complexing agent, and methyl hydroquinone and phenolsulfonic acid as a tin antioxidant.

In the present invention, specimen were plated using the plating baths according to Examples 5 to 21. A working temperature was 35°C, working current density was about 3.0 ASD, a plating time was 7 minutes, and a plated thickness was 8.75 µm. The plating anode used Sn95wt%Pb5wt%, and by using the tin-lead plating anode as such, the bismuth ion in the solution in the absence of electricity would alleviate the substitution of the bismuth metal naturally generated due to the voltage difference of the tin-lead plating anode. The potential difference between Sn and Pb is -0.12 & -0.13Volt, which is not a big difference, but the standard potential difference of Bi metal is + 0.215Volt, which may lead to a natural substitution reaction of tin and lead.

Also, by using a tin-lead plating anode, the concentration of tin and lead in a solution can be controlled by an anode, and the ternary alloy ratio can be easily managed and maintained by controlling only bismuth ions.

### Example 5

150 ml/l of stannous methanesulfonic acid, 0.5 ml/l of lead methanesulfonic acid, and 10.0 ml/l of bismuth methanesulfonic acid were added to control the amount of tin ions (Sn²⁺) to 50.0 g/l, the amount of lead ions (Pb²⁺) to 0.25 g/l, and the amount of bismuth ions (Bi³⁺) to 2.0 g/l. A solution for plating was obtained using 200 g/l of methane sulfonic acid as an electrolyte, 6 g/l of octyl phenol ethoxylate, 1.0 g/l of Tamol NN8906, 0.1 g/l of phenyl urea, 1.0 g/l of methyl hydroquinone, and 20 g/l of phenolsulfonic acid, and the specimen was plated by working under the above conditions.

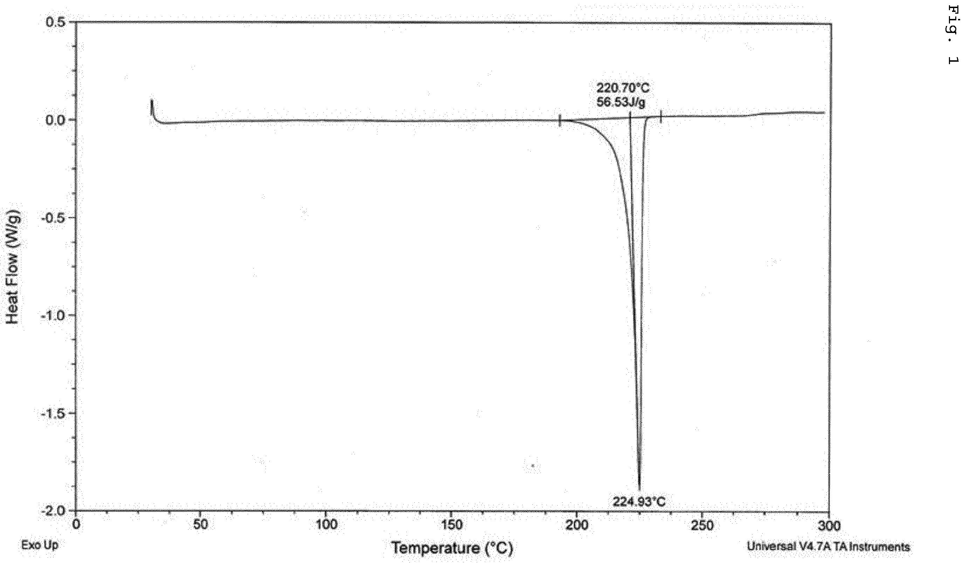

The component ratio of the ternary alloy plated composition of Example 5 was analyzed by ICP. Consequently, tin was 94.39 wt%, bismuth was 4.43 wt%, and lead was 1.18 wt%. The DSC measured results of a melting point are shown in FIG. 1. A melting range was 220.70-224.93°C. The resulting temperature was 20°C or lower than that of the conventional case and was a significant result.

### Example 6

150 ml/l of stannous methanesulfonic acid, 1.0 ml/l of lead methanesulfonic acid, and 10.0 ml/l of bismuth methanesulfonic acid were added to control the amount of tin ions (Sn²⁺) to 50.0 g/l, the amount of lead ions (Pb²⁺) to 0.5 g/l, and the amount of bismuth ions (Bi³⁺) to 2.0 g/l. The other electrolytes and additives were the same as those of the plating solution of Example 5, and the specimen was plated by working under the same conditions.

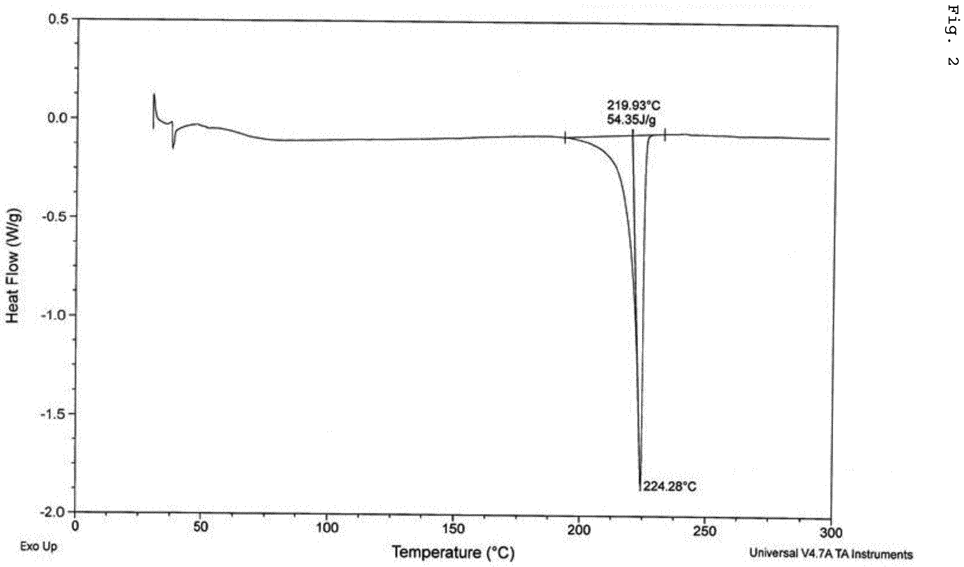

The component ratio of the ternary alloy plated composition of Example 6 was analyzed by ICP. Consequently, tin was 93.92 wt%, bismuth was 4.06 wt%, and lead was 2.02 wt%. The DSC measured results of a melting point are shown in FIG. 2. The melting range was 219.93-224.28°C. The resulting temperature was improved when compared to that of Example 5.

### Example 7

150 ml/l of stannous methanesulfonic acid, 2.0 ml/l of lead methanesulfonic acid, and 10.0 ml/l of bismuth methanesulfonic acid were added to control the amount of tin ions (Sn²⁺) to 50.0 g/l, the amount of lead ions (Pb²⁺) to 1.0 g/l, and the amount of bismuth ions (Bi³⁺) to 2.0 g/l. The other electrolytes and additives were the same as those of the plating solution of Example 5, and the specimen was plated by working under the same conditions.

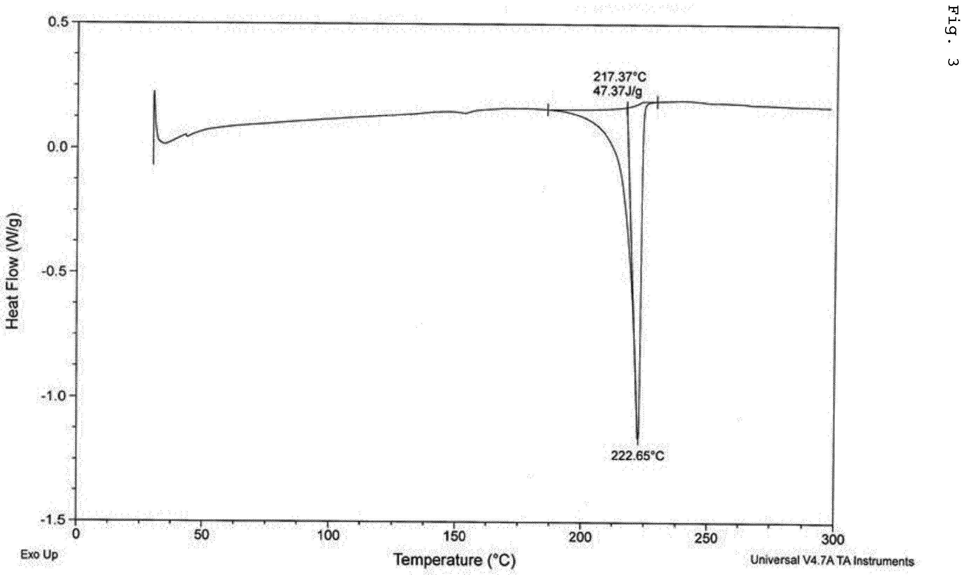

The component ratio of the ternary alloy plated composition of Example 7 was analyzed by ICP. Consequently, tin was 92.49 wt%, bismuth was 4.47 wt%, and lead was 3.08 wt%. The DSC measured results of a melting point are shown in FIG. 3. The melting range was 217.37-222.65°C. The resulting temperature was improved when compared to that of Example 6.

### Example 8

150 ml/l of stannous methanesulfonic acid, 3.0 ml/l of lead methanesulfonic acid, and 10.0 ml/l of bismuth methanesulfonic acid were added to control the amount of tin ions (Sn²⁺) to 50.0 g/l, the amount of lead ions (Pb²⁺) to 1.5 g/l, and the amount of bismuth ions (Bi³⁺) to 2.0 g/l. The other electrolytes and additives were the same as those of the plating solution of Example 5, and the specimen was plated by working under the same conditions.

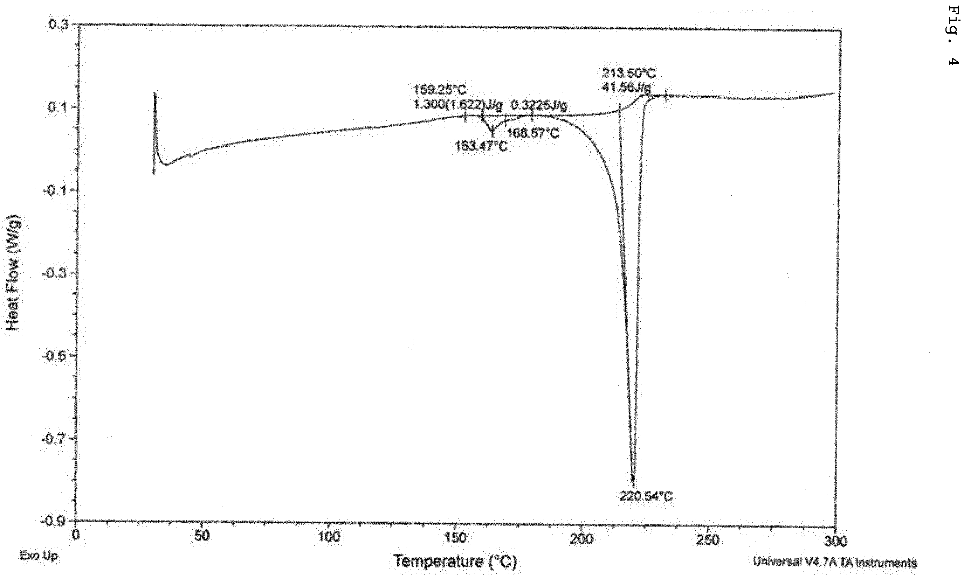

The component ratio of the ternary alloy plated composition of Example 8 was analyzed by ICP. Consequently, tin was 91.37 wt%, bismuth was 4.43 wt%, and lead was 4.20 wt%. The DSC measured results of a melting point are shown in FIG. 4. The melting range was 159.25-220.54°C. The resulting temperature was improved when compared to that of Example 7. As shown in FIG. 4, the melting of the plated composition was started at 159.25°C. And a heat at 213.54°C was 41.56 J/g.

### Example 9

150 ml/l of stannous methanesulfonic acid, 3.6 ml/l of lead methanesulfonic acid, and 10.5 ml/l of bismuth methanesulfonic acid were added to control the amount of tin ions (Sn²⁺) to 50.0 g/l, the amount of lead ions (Pb²⁺) to 1.8 g/l, and the amount of bismuth ions (Bi³⁺) to 2.1 g/l. The other electrolytes and additives were the same as those of the plating solution of Example 5, and the specimen was plated by working under the same conditions.

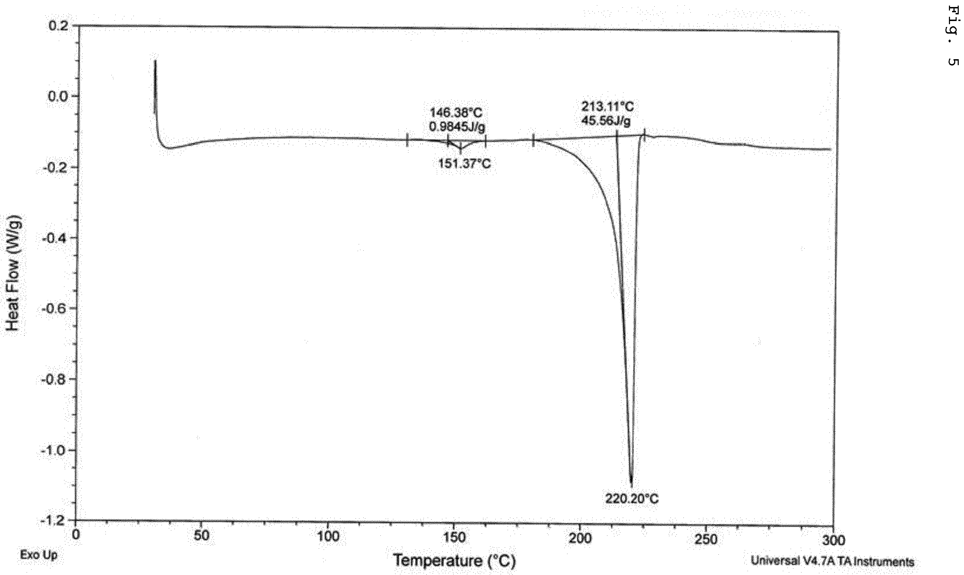

The component ratio of the ternary alloy plated composition of Example 9 was analyzed by ICP. Consequently, tin was 90.85 wt%, bismuth was 4.19 wt%, and lead was 4.96 wt%. The DSC measured results of a melting point are shown in FIG. 5. A melting range was 146.38-220.20°C. The resulting temperature was improved when compared to that of Example 8. The melting point was the lowest among the examples. As shown in FIG. 5, the melting of the composition was started at 146.38°C.

### Example 10

150 ml/l of stannous methanesulfonic acid, 3.8 ml/l of lead methanesulfonic acid, and 12 ml/l of bismuth methanesulfonic acid were added to control the amount of tin ions (Sn²⁺) to 50.0 g/l, the amount of lead ions (Pb²⁺) to 1.9 g/l, and the amount of bismuth ions (Bi³⁺) to 2.4 g/l. The other electrolytes and additives were the same as those of the plating solution of Example 5, and the specimen was plated by working under the same conditions.

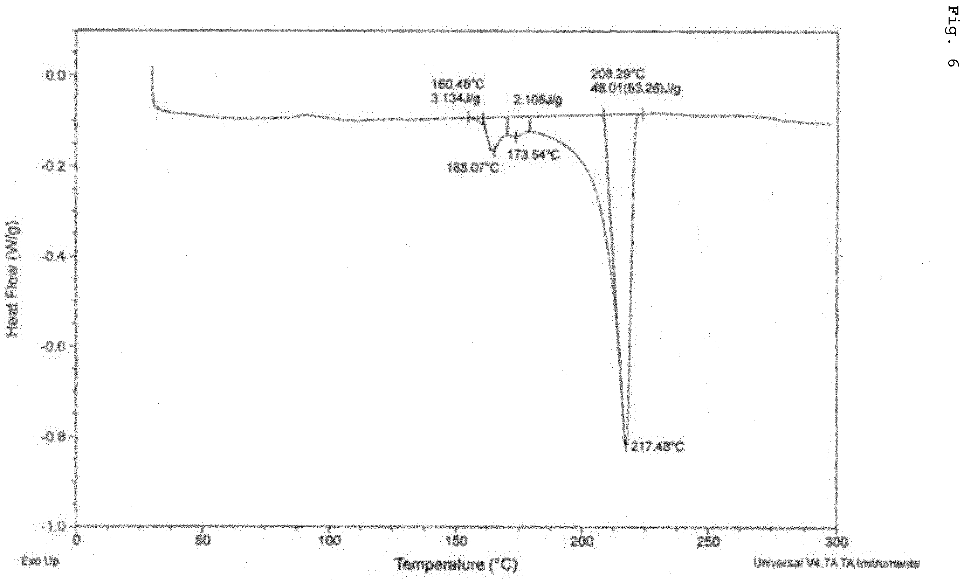

The component ratio of the ternary alloy plated composition of Example 10 was analyzed by ICP. Consequently, tin was 90.82 wt%, bismuth was 4.13 wt%, and lead was 5.05 wt%. The DSC measured results of a melting point are shown in FIG. 6. The melting range was 160.48-217.48°C. Also showed meaningful results.

### Example 11

150 ml/l of stannous methanesulfonic acid, 9.5 ml/l of lead methanesulfonic acid, and 11 ml/l of bismuth methanesulfonic acid were added to control the amount of tin ions (Sn²⁺) to 50.0 g/l, the amount of lead ions (Pb²⁺) to 4.75 g/l, and the amount of bismuth ions (Bi³⁺) to 2.2 g/l. The other electrolytes and additives were the same as those of the plating solution of Example 5, and the specimen was plated by working under the same conditions.

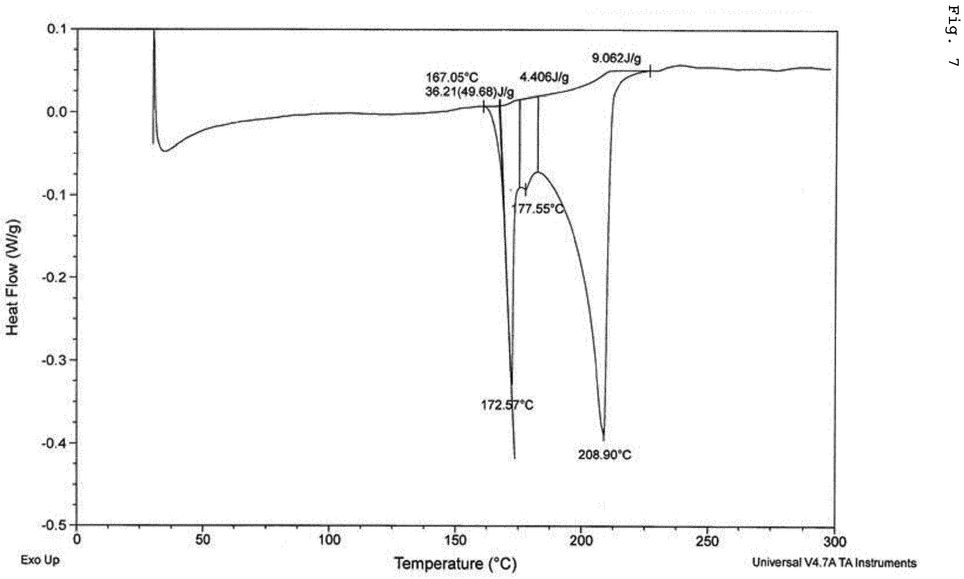

The component ratio of the ternary alloy plated composition of Example 11 was analyzed by ICP. Consequently, tin was 86.25 wt%, bismuth was 4.10 wt%, and lead was 9.65 wt%. The DSC measured results of a melting point are shown in FIG. 7. The melting range was 167.05-208.90°C. Also showed meaningful results.

### Example 12

150 ml/l of stannous methanesulfonic acid, 11.4 ml/l of lead methanesulfonic acid, and 15.0 ml/l of bismuth methanesulfonic acid were added to control the amount of tin ions (Sn²⁺) to 50.0 g/l, the amount of lead ions (Pb²⁺) to 5.7 g/l, and the amount of bismuth ions (Bi³⁺) to 3.0 g/l. The other electrolytes and additives were the same as those of the plating solution of Example 5, and the specimen was plated by working under the same conditions.

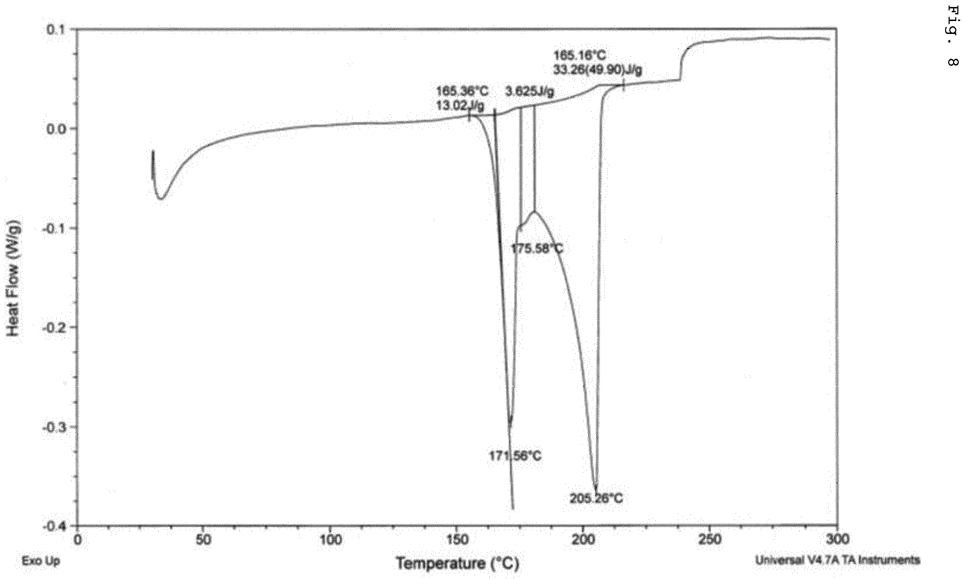

The component ratio of the ternary alloy plated composition of Example 12 was analyzed by ICP. Consequently, tin was 82.25 wt%, bismuth was 4.99 wt%, and lead was 12.76 wt%. The DSC measured results of a melting point are shown in FIG. 8. The melting range was 165.36-205.26°C. Also showed meaningful results.

### Example 13

150 ml/l of stannous methanesulfonic acid, 10.0 ml/l of lead methanesulfonic acid, and 11.0 ml/l of bismuth methanesulfonic acid were added to control the amount of tin ions (Sn²⁺) to 50.0 g/l, the amount of lead ions (Pb²⁺) to 5.0 g/l, and the amount of bismuth ions (Bi³⁺) to 2.2 g/l. The other electrolytes and additives were the same as those of the plating solution of Example 5, and the specimen was plated by working under the same conditions.

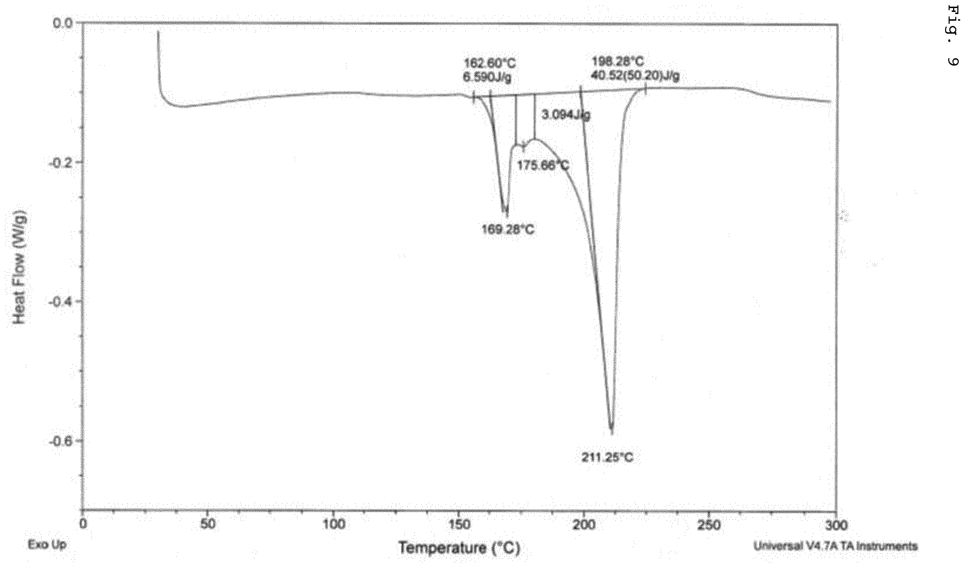

The component ratio of the ternary alloy plated composition of Example 13 was analyzed by ICP. Consequently, tin was 83.60 wt%, bismuth was 4.39 wt%, and lead was 12.01 wt%. The DSC measured results of a melting point are shown in FIG. 9. The melting range was 162.60-211.25°C. Also showed meaningful results.

### Example 14

150 ml/l of stannous methanesulfonic acid, 16.0 ml/l of lead methanesulfonic acid, and 10.0 ml/l of bismuth methanesulfonic acid were added to control the amount of tin ions (Sn²⁺) to 50.0 g/l, the amount of lead ions (Pb²⁺) to 8.0 g/l, and the amount of bismuth ions (Bi³⁺) to 2.0 g/l. The other electrolytes and additives were the same as those of the plating solution of Example 5, and the specimen was plated by working under the same conditions.

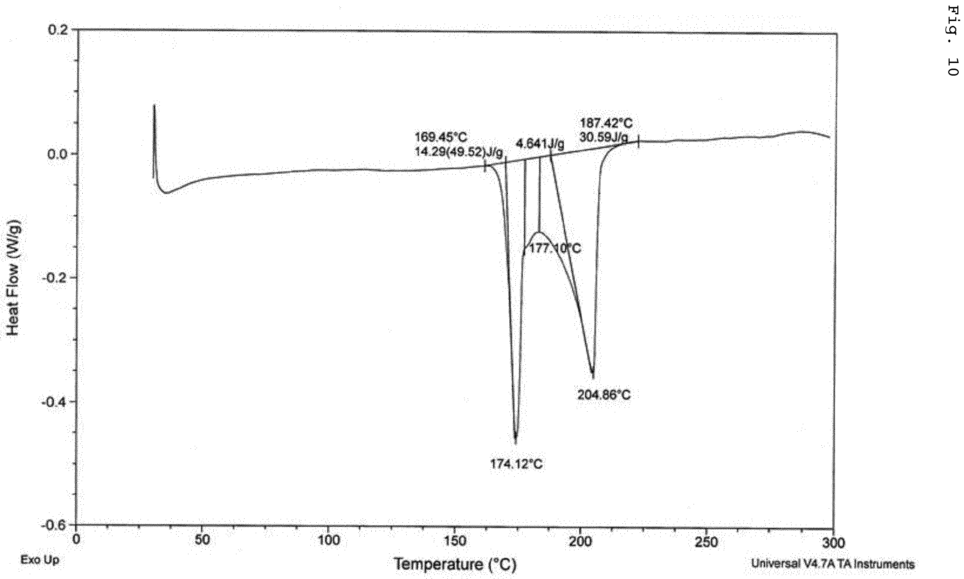

The component ratio of the ternary alloy plated composition of Example 14 was analyzed by ICP. Consequently, tin was 80.34 wt%, bismuth was 4.55 wt%, and lead was 15.11 wt%. The DSC measured results of a melting point are shown in FIG. 10. The melting range was 169.45-204.86°C. Also showed meaningful results.

### Example 15

150 ml/l of stannous methanesulfonic acid, 16.6 ml/l of lead methanesulfonic acid, and 10.0 ml/l of bismuth methanesulfonic acid were added to control the amount of tin ions (Sn²⁺) to 50.0 g/l, the amount of lead ions (Pb²⁺) to 8.3 g/l, and the amount of bismuth ions (Bi³⁺) to 2.0 g/l. The other electrolytes and additives were the same as those of the plating solution of Example 5, and the specimen was plated by working under the same conditions.

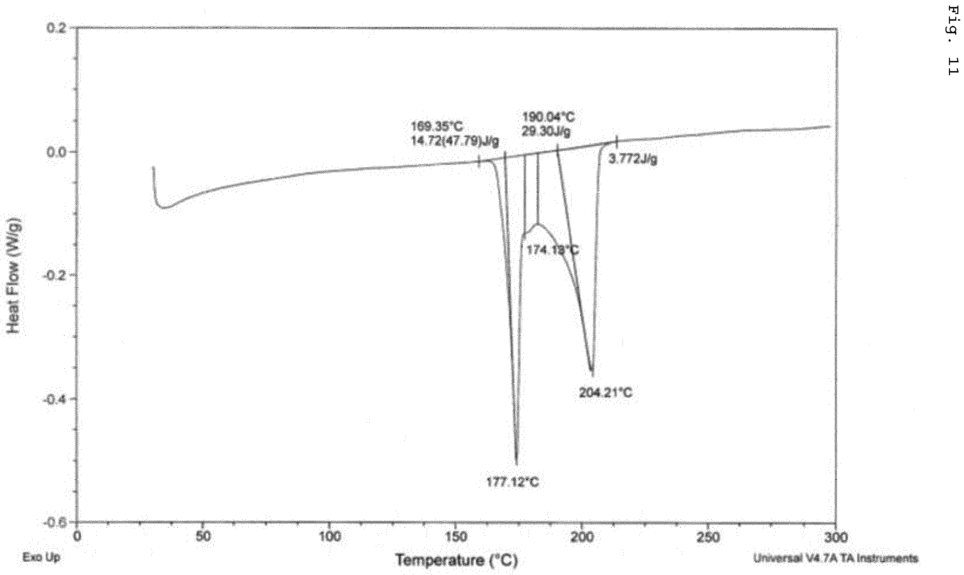

The component ratio of the ternary alloy plated composition of Example 15 was analyzed by ICP. Consequently, tin was 79.35 wt%, bismuth was 4.19 wt%, and lead was 16.46 wt%. The DSC measured results of a melting point are shown in FIG. 11. The melting range was 169.35-204.21°C. Also showed meaningful results.

### Example 16

150 ml/l of stannous methanesulfonic acid, 22.0 ml/l of lead methanesulfonic acid, and 9.0 ml/l of bismuth methanesulfonic acid were added to control the amount of tin ions (Sn²⁺) to 50.0 g/l, the amount of lead ions (Pb²⁺) to 11.0 g/l, and the amount of bismuth ions (Bi³⁺) to 1.8 g/l. The other electrolytes and additives were the same as those of the plating solution of Example 5, and the specimen was plated by working under the same conditions.

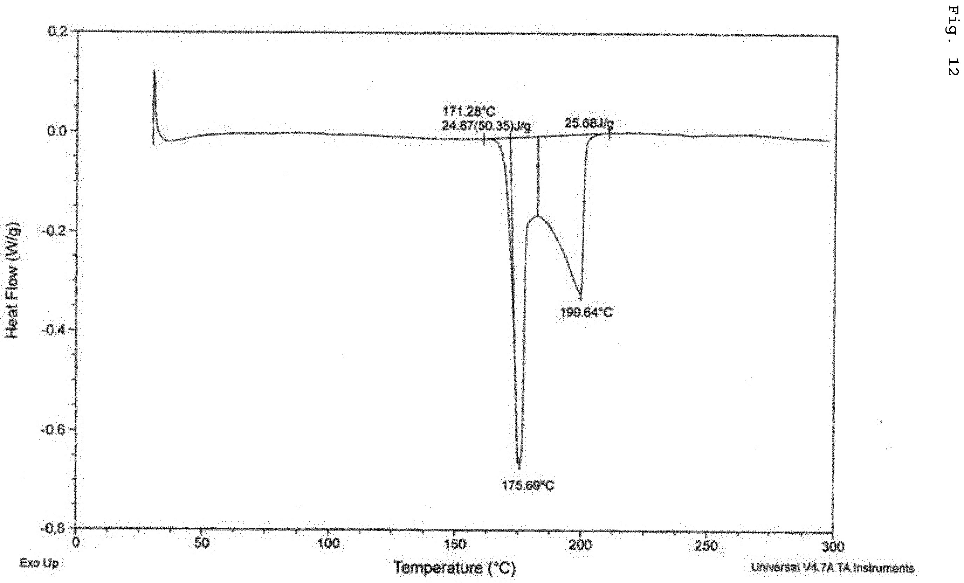

The component ratio of the ternary alloy plated composition of Example 16 was analyzed by ICP. Consequently, tin was 74.07 wt%, bismuth was 4.56 wt%, and lead was 21.37 wt%. The DSC measured results of a melting point are shown in FIG. 12. The melting range was 171.28-199.64°C. Also showed meaningful results.

### Example 17

150 ml/l of stannous methanesulfonic acid, 20.6 ml/l of lead methanesulfonic acid, and 9.5 ml/l of bismuth methanesulfonic acid were added to control the amount of tin ions (Sn²⁺) to 50.0 g/l, the amount of lead ions (Pb²⁺) to 10.3 g/l, and the amount of bismuth ions (Bi³⁺) to 1.9 g/l. The other electrolytes and additives were the same as those of the plating solution of Example 5, and the specimen was plated by working under the same conditions.

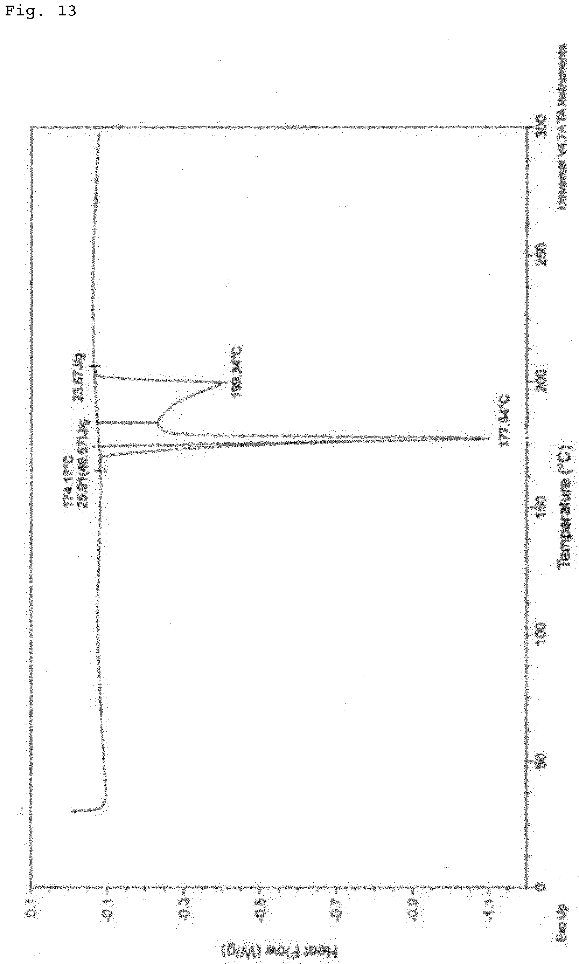

The component ratio of the ternary alloy plated composition of Example 17 was analyzed by ICP. Consequently, tin was 74.20 wt%, bismuth was 4.00 wt%, and lead was 21.80 wt%. The DSC measured results of a melting point are shown in FIG. 13. The melting range was 174.17-199.34°C. Also showed meaningful results.

### Example 18

150 ml/l of stannous methanesulfonic acid, 30.0 ml/l of lead methanesulfonic acid, and 7.5 ml/l of bismuth methanesulfonic acid were added to control the amount of tin ions (Sn²⁺) to 50.0 g/l, the amount of lead ions (Pb²⁺) to 15.0 g/l, and the amount of bismuth ions (Bi³⁺) to 1.9 g/l. The other electrolytes and additives were the same as those of the plating solution of Example 5, and the specimen was plated by working under the same conditions.

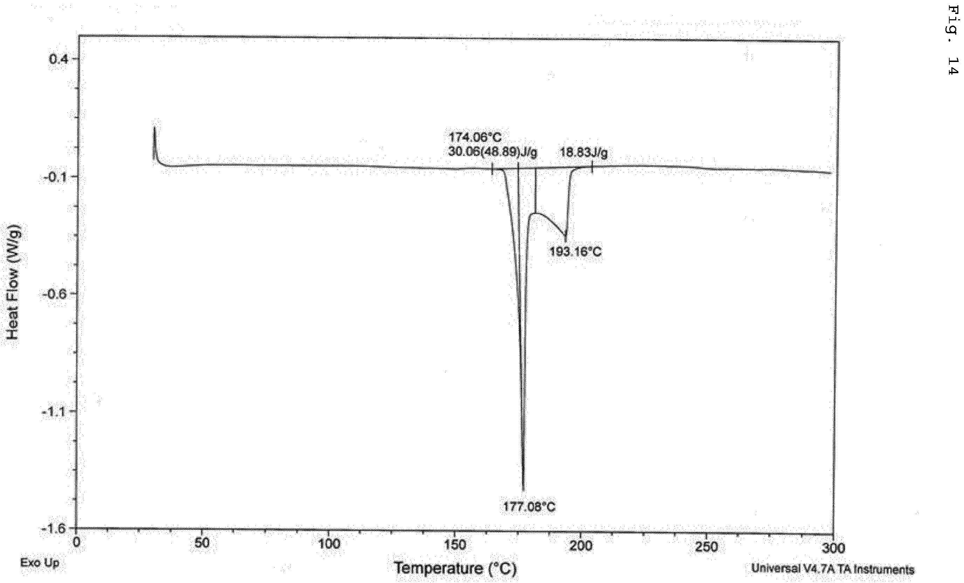

The component ratio of the ternary alloy plated composition of Example 18 was analyzed by ICP. Consequently, tin was 69.08 wt%, bismuth was 4.58 wt%, and lead was 26.34 wt%. The DSC measured results of a melting point are shown in FIG. 14. The melting range was 174.06-193.16°C. Also showed meaningful results.

### Example 19

150 ml/l of stannous methanesulfonic acid, 26.6 ml/l of lead methanesulfonic acid, and 9.0 ml/l of bismuth methanesulfonic acid were added to control the amount of tin ions (Sn²⁺) to 50.0 g/l, the amount of lead ions (Pb²⁺) to 13.3 g/l, and the amount of bismuth ions (Bi³⁺) to 1.8 g/l. The other electrolytes and additives were the same as those of the plating solution of Example 5, and the specimen was plated by working under the same conditions.

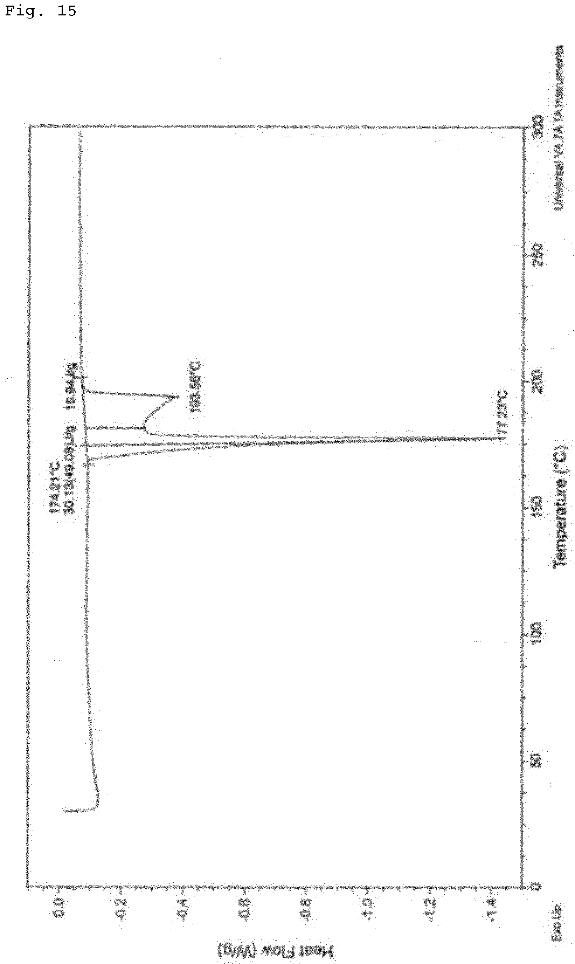

The component ratio of the ternary alloy plated composition of Example 19 was analyzed by ICP. Consequently, tin was 71.32 wt%, bismuth was 4.21 wt%, and lead was 24.47 wt%. The DSC measured results of a melting point are shown in FIG. 15. The melting range was 174.21-193.56°C. Also showed meaningful results.

### Example 20

150 ml/l of stannous methanesulfonic acid, 34.0 ml/l of lead methanesulfonic acid, and 8.5 ml/l of bismuth methanesulfonic acid were added to control the amount of tin ions (Sn²⁺) to 50.0 g/l, the amount of lead ions (Pb²⁺) to 17.0 g/l, and the amount of bismuth ions (Bi³⁺) to 1.7 g/l. The other electrolytes and additives were the same as those of the plating solution of Example 5, and the specimen was plated by working under the same conditions.

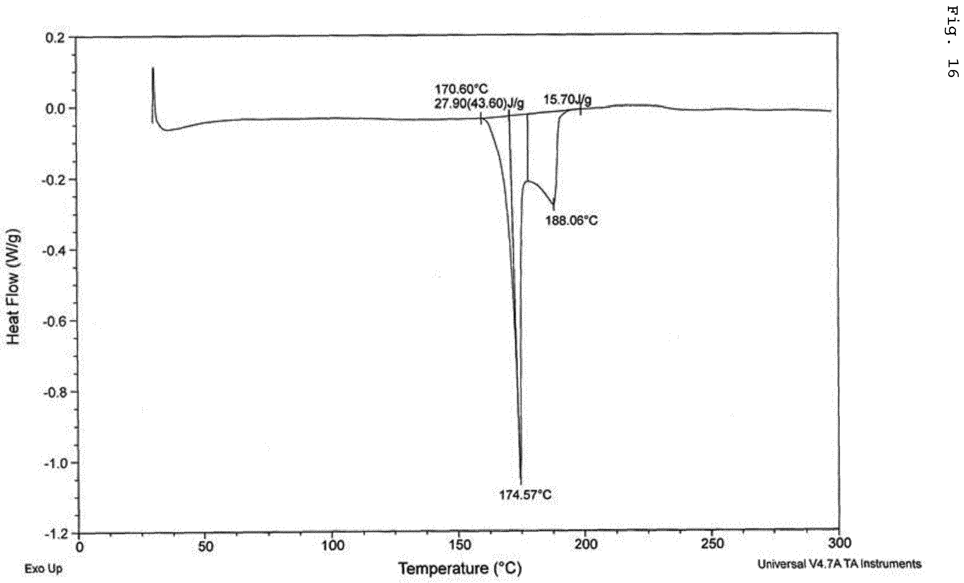

The component ratio of the ternary alloy plated composition of Example 20 was analyzed by ICP. Consequently, tin was 66.22 wt%, bismuth was 4.37 wt%, and lead was 29.41 wt%. The DSC measured results of a melting point are shown in FIG. 16. The melting range was 170.60-188.06°C. Also showed meaningful results.

### Example 21

150 ml/l of stannous methanesulfonic acid, 42.0 ml/l of lead methanesulfonic acid, and 8.0 ml/l of bismuth methanesulfonic acid were added to control the amount of tin ions (Sn²⁺) to 50.0 g/l, the amount of lead ions (Pb²⁺) to 21.0 g/l, and the amount of bismuth ions (Bi³⁺) to 1.6 g/l. The other electrolytes and additives were the same as those of the plating solution of Example 5, and the specimen was plated by working under the same conditions.

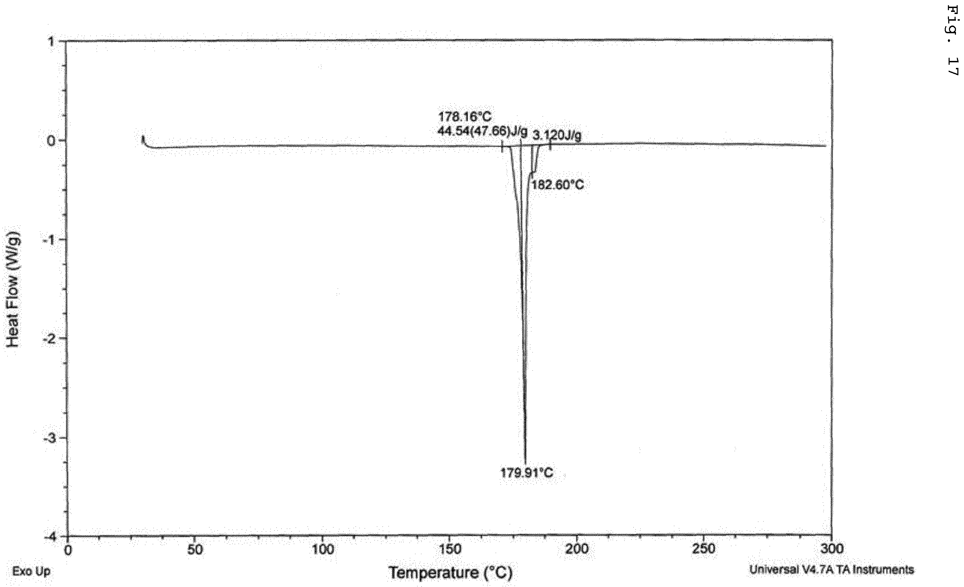

The component ratio of the ternary alloy plated composition of Example 21 was analyzed by ICP. Consequently, tin was 59.20 wt%, bismuth was 4.29 wt%, and lead was 36.51 wt%. The DSC measured results of a melting point are shown in FIG. 17. The melting range was 178.16-182.60°C. Also showed meaningful results.

In the following Table 1, the weight ratios and melting ranges of the ternary alloy plating compositions according to Examples 5 to 21 are shown.

**[Table 1]**

| | Sn | Bi | Pb | Melting range (°C) |
|---|---|---|---|---|
| Example 5 | 94.39 | 4.43 | Pb1.18 | 220.70 |
| | | | Pb1.18 | 224.93 |
| Example 6 | 93.32 | 4.06 | Pb2.02 | 219.93 |
| | | | Pb2.02 | 224.28 |
| Example 7 | 92.49 | 4.47 | Pb3.08 | 217.37 |
| | | | Pb3.08 | 222.65 |
| Example 8 | 91.37 | 4.43 | Pb4.20 | 159.25 |
| | | | Pb4.20 | 220.54 |
| Example 9 | 90.85 | 4.19 | Pb4.96 | 146.38 |
| | | | Pb4.96 | 220.20 |
| Example 10 | 90.82 | 4.13 | Pb-5.05 | 160.48 |
| | | | Pb-5.05 | 217.48 |
| Example 11 | 86.25 | 4.10 | Pb-9.65 | 167.05 |
| | | | Pb-9.65 | 208.90 |
| Example 12 | 82.25 | 4.99 | Pb-12.76 | 165.36 |
| | | | Pb-12.76 | 205.26 |
| Example 13 | 83.60 | 4.39 | Pb-12.01 | 162.60 |
| | | | Pb-12.01 | 211.25 |
| Example 14 | 80.34 | 4.55 | Pb-15.11 | 169.45 |
| | | | Pb-15.11 | 204.86 |
| Example 15 | 79.35 | 4.19 | Pb-16.46 | 169.35 |
| | | | Pb-16.46 | 204.21 |
| Example 16 | 74.07 | 4.56 | Pb-21.37 | 171.28 |
| | | | Pb-21.37 | 199.64 |
| Example 17 | 74.20 | 4.00 | Pb-21.80 | 174.17 |
| | | | Pb-21.80 | 199.34 |
| Example 18 | 69.08 | 4.58 | Pb-26.34 | 174.06 |
| | | | Pb-26.34 | 193.16 |
| Example 19 | 71.32 | 4.21 | Pb-24.47 | 174.21 |
| | | | Pb-24.47 | 193.56 |
| Example 20 | 66.22 | 4.37 | Pb-29.41 | 170.60 |
| | | | Pb-29.41 | 188.06 |
| Example 21 | 59.20 | 4.29 | Pb-36.51 | 178.16 |
| | | | Pb-36.51 | 182.60 |

The initial melting point of the lowest temperature, as shown in Table 1 above, was 146.38°C as the result of Example 9, which was the closest to the theoretical prediction. The highest melting point was found to be 224.93°C in Example 5. Both of which were lower than the heating temperature of soldering at 240 to 250°C when solder of 63% tin and 37% lead was used as a comparative example at the time of plating the conventional solar cell taping ribbon, which was a significant result.

On the other hand, when the plating specimens were observed, no problem of brittleness was found. In the embodiment of the present invention, the highest content of bismuth was 4.99wt% in the tin-lead-bismuth ternary alloy. Experimental results were in agreement with the prediction that the content of bismuth should be controlled to 5wt% or less.

Examples of brittle test of the plating specimen are shown in Table 2 below. A foil-shaped plating specimen was prepared, and the Bi concentration was varied after the Pb content was fixed to about 10wt%. After heat treatment at 180 degrees, a sample was folded and unfolded, and then, restoration degree was observed. As a result of brittleness observation according to the content of Bi, restoration of 4.65 wt% of bismuth was restored without any damage to the sample. However, in the case of 6.16wt% of bismuth, a partial breakage was observed even though restoration was performed. In case of 10.32wt% of bismuth, folded portion was broken and it was confirmed that there was almost no restoring force. In the case of 5wt% bismuth content due to the change of lead content, partial breakage occurs due to the change of lead content. However, in all the plating specimens of Examples 1 to 21 having a bismuth content of 5wt% or less, partial breakage such as the 6.16 wt% content did not occur.

**[Table 2]**

| | Bi content (wt%) | | |
|---|---|---|---|
| | 4.65 | 6.16 | 10.32 |
| After restoration test | Restored without particular damage | Partially broken | Severely damaged and impossibly restored |

Through the above-described embodiments, it has been confirmed that a low melting point solder can be obtained in the alloy ratio to be implemented in the present invention. It is industrially applicable to the bonding technology widely used in the solar cell industry such as tabbing ribbons, interconnect wires, and smart wires as well as other electronic parts industries. Such an alloy composition can also be prepared by electroplating as described above.

On the other hand, the present invention can contribute to weight reduction of the solar cell module compared with the conventional use of the tabbing ribbon of Sn63Pb37. For example, the weight of the tabbing ribbon of 14.06% for Sn92Pb4Bi4 and 10.38% for Sn84Pb12Bi4 alloy of the present invention can be reduced, which contributes to the weight reduction of the solar cell module. The weight of 60 solar modules is 18∼19kg, the weight of ribbon (0.3mm thickness, Sn63: Pb37) is 50∼60g/module and the ratio of ribbon weight to module weight is about 0.26 to 0.33%. When the Sn63Pb37 ribbon is replaced with the ribbon of the Sn92Pb4Bi4 ternary alloy, the weight of the tabbing ribbon is reduced to 14.06%, which is about 1.41∼1.69g reduction effect. When the Sn84Pb12Bi4 ternary alloy is applied as a solder material, the weight reduction ratio of the taping ribbon is 10.38%, which results in a reduction of 1.04 to 1.25g per module.

The scope of protection of the present invention is not limited to the description and the expression of the embodiments explicitly described in the foregoing. It is again to be understood that the present invention is not limited by the modifications or the substitutions that are obvious to those skilled in the art.

## Claims

1. A Sn-Pb-Bi ternary alloy solder composition comprising 5 wt% or less of bismuth (Bi), wherein a melting point of the Sn-Pb-Bi ternary alloy solder is determined in 146-225°C range.

2. The Sn-Pb-Bi ternary alloy solder composition of claim 1, wherein an amount of lead (Pb) is 1-36 wt%.

3. The Sn-Pb-Bi ternary alloy solder composition of claim 2, wherein an amount of Bi is maintained in the 4wt% range.

4. A Sn-Pb-Bi ternary alloy solder composition, comprising 2.5-5 wt% of Bi, 1-36 wt% of Pb, and a remaining amount of tin (Sn).

5. A method of electroplating for obtaining a Sn-Pb-Bi ternary alloy solder composition, wherein a Sn-Pb alloy is used as a positive electrode, and metal ions in a plating bath include stannous methanesulfonic acid, lead methanesulfonic acid, and bismuth methanesulfonic acid.

6. A solar cell module manufactured by connecting an electrode and another electrode of a substrate by an interconnect medium using a Sn-Pb-Bi ternary alloy solder composition according to any one of claims 1 to 4.

7. The solar cell module of claim 6, wherein the interconnect medium is used for one of a tabbing ribbon, a multi bus bar wire, and a smart wire.
